# EUROPÄISCHE PATENTSCHRIFT

(11) **EP 0 627 675 B1**
(45) Veröffentlichungstag und Bekanntmachung des Hinweises auf die Patenterteilung: **13.06.2001**
(21) Anmeldenummer: 94103915.8
(22) Anmeldetag: 14.03.1994
(51) Int. Cl.: G03H 1/26, G11C 13/04

(54) **Diffraktive optische Einrichtung zur optischen Abbildung eines Raumpunktes auf andere Raumpunkte**
Diffractive optical device for the optical imaging of one space point on other space points
Dispositif optique de diffraction pour la reproduction optique d'un point spatial sur d'autres points spatiaux

(30) Priorität: 16.04.1993 DE 4312382
(43) Veröffentlichungstag der Anmeldung: 07.12.1994
(73) Patentinhaber: Infineon Technologies AG, 81669 München (DE)
(72) Erfinder: Zarschizky, Helmut, Dr., D-81541 München (DE); Karstensen, Holger, Dr., D-85662 Hohenbrunn (DE)
(74) Vertreter: Zedlitz, Peter, Dipl.-Inf.

(56) Entgegenhaltungen:
- EP-A- 0 002 043
- DE-A- 2 313 924
- FR-A- 2 105 869
- US-A- 3 841 729
- US-A- 4 170 396
- US-A- 4 421 380

## Beschreibung

Diffraktive optische Einrichtung zur optischen Abbildung eines Raumpunktes auf andere Raumpunkte

Die Erfindung betrifft eine diffraktive optische Einrichtung zur optischen Abbildung eines Raumpunktes auf zumindest zwei andere Raumpunkte.

Diffraktive optische Einrichtungen sind beispielsweise aus US-A-4 170 396 oder US-A- 3 841 729 bekannt.

Diffraktive optische Einrichtungen, insbesondere Einrichtungen, die Strahlteilerfunktionen ausüben, können auf verschiedene Weise hergestellt werden. Sie können interferometrisch durch Belichtung eines hochauflösenden Photomaterials, beispielsweise Dichromat-Gelatine, direkt mittels Holographie aufgenommen werden, oder sie können synthetischer Art sein. Bei synthetischen diffraktiven optischen Einrichtungen wird das Beugungsmuster bzw. die lichtbeugende Struktur der Einrichtung im Computer berechnet, der Datensatz dann so aufbereitet, daß entweder eine Maske hergestellt wird, die für Kontakt- oder Projektionslithographie dient, oder daß die lichtbeugende Struktur direkt auf das mit Photoresist beschichtete Trägersubstrat geschrieben wird, beispielsweise mittels Elektronenstrahllithographie.

Ein Problem der Direktaufnahme ist, daß bei Anwendungen im Infrarotbereich oberhalb 800 nm Lichtwellenlänge keine genügend empfindlichen Photomaterialien zur Verfügung stehen, so daß ein Umweg eingeschlagen werden muß, der die interferometrische Aufnahme bei sichtbarer Wellenlänge - meist im blauen Spektralbereich - und eine verzerrte Aufnahmegeometrie bedingt. Sind diffraktive optische Einrichtungen mit einem Fan Out < 1 erforderlich und sollen die Ausgangsstrahlen unter beliebigen Ablenkwinkeln abgestrahlt werden, kann eine solche diffraktive optische Einrichtung nicht mehr interferometrisch aufgezeichnet werden. Das Problem des Wellenlängenunterschiedes zwischen Aufnahme und Einsatz der Einrichtung kann für eine holographische Einrichtung nicht mehr durch einfache Variation der Aufnahmegeometrie gelöst werden. Für derartige Aufgaben sind synthetische holographisch optische oder spezielle diffraktive Einrichtungen erforderlich.

Ein zentrales Problem der synthetischen Einrichtungen ist der begrenzte Beugungswirkungsgrad, der bei binären phasenmäßigen diffraktiven optischen Einrichtungen bei maximal 40 % liegt. Eine Erhöhung dieses Wirkungsgrades ist zwar durch eine Profilierung der Gitterfurchen der Einrichtungen möglich, allerdings steigt der Fertigungsaufwand beträchtlich an. Schon für die Berechnung der Einrichtungen ist ein leistungsfähiger Rechner hoher Speicherkapazität und Geschwindigkeit erforderlich. Für anwendungsfreundliche Einrichtungen, die kurze Brennweiten und auch große Ablenkwinkel bedingen, sind Technologien, wie Elektronenstrahllithographie, Ionenätztechniken und Aufdampfprozesse erforderlich, die zwar aufwendig, aber beherrschbar sind.

Der im Anspruch 1 angegebenen Erfindung liegt die Aufgabe zugrunde, eine diffraktive optische Einrichtung der eingangs genannten Art anzugeben, deren Berechnung und Kodierung eine beherrschbare Menge von Strukturdaten gestattet, die überdies trotz eines hohen Fan Outs akzeptable Strahlqualität aufweist und deren Wirkungsgrad bei 40 % oder deutlich darüber liegt.

Diese Aufgabe wird durch die im kennzeichnenden Teil des Anspruchs 1 angegebenen Merkmale gelöst.

Bevorzugte und vorteilhafte Ausgestaltungen der erfindungsgemäßen Einrichtung gehen aus den Unteransprüchen hervor.

Die erfindungsgemäße Einrichtung ermöglicht einen hohen Fan Out mit guter Qualität der einzelnen Ausgangsstrahlen. Sie kann in Reflexion, beispielsweise als Spiegel mit vielen Brennpunkten, oder in Transmission, beispielsweise als multi-fokale Linse, betrieben werden. Es können mehrere optische Funktionen mit einer einzigen planaren erfindungsgemäßen Einrichtung ausgeführt werden. Eine erfindungsgemäße Einrichtung mit Fan Out ist ein Strahlteiler, der beliebige Ablenkwinkel für die individuellen Strahlen aufweisen kann. Außerdem können diese Strahlen auch fokussiert werden. Eine erfindungsgemäße optische Einrichtung ist für optische Freistrahlverbindungen geeignet und kann für die optische Taktsignalverteilung in Rechnern, in der Board- oder Chipebene eingesetzt werden.

Die Erfindungsgemäße Einrichtung hat für Fan Out < 100 gegenüber einer holographisch optischen Einrichtung, welche die gleiche Funktion ausführen kann, Vorteile. Aufgrund des räumlichen Multiplexcharakters ist die lichtbeugende Struktur einer holographisch optischen Einrichtung sehr kompliziert. Dies führt bei synthetischen, computergenerierten Einrichtungen zu aufwendigen Kodierverfahren und enormen Datenmengen. Die erfindungsgemäße Einrichtung ist aus vielen einzelnen Strukturteilbereichen bzw. Facetten zusammengesetzt, die einfache Beugungsgitterstrukturen enthalten. Dies sind im allgemeinen gekrümmte Gitter. Gegenüber der holographisch optischen Einrichtung wird die Kodierung wesentlich einfacher und die Datenmenge deutlich reduziert. Ein weiterer Vorteil der erfindungsgemäßen Einrichtung liegt darin, daß den Beugungsgitterstrukturen der einzelnen Strukturteilbereiche ein geeignetes Profil gegeben werden kann, wodurch sich der Wirkungsgrad wesentlich erhöht. Vorteilhafterweise kann ein Fan Out bis zu 100 erreicht werden.

Die Erfindung wird in der nachfolgenden Beschreibung anhand der Figuren beispielhaft näher erläutert. Es zeigen:
- Figur 1: in perspektivischer Darstellung eine beispielhafte Anordnung mit einer erfindungsgemäßen diffraktiven Einrichtung mit Fan Out 4, die einen schräg einfallenden und stark divergenten Laserstrahl einer Laserdiode auf vier optische Detektoren richtet,

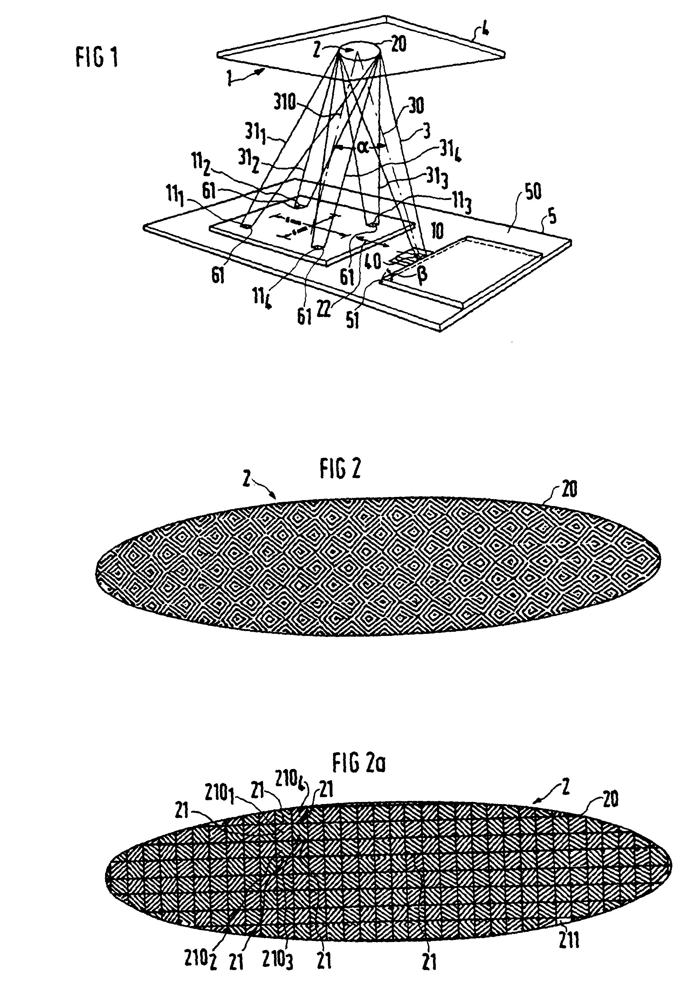

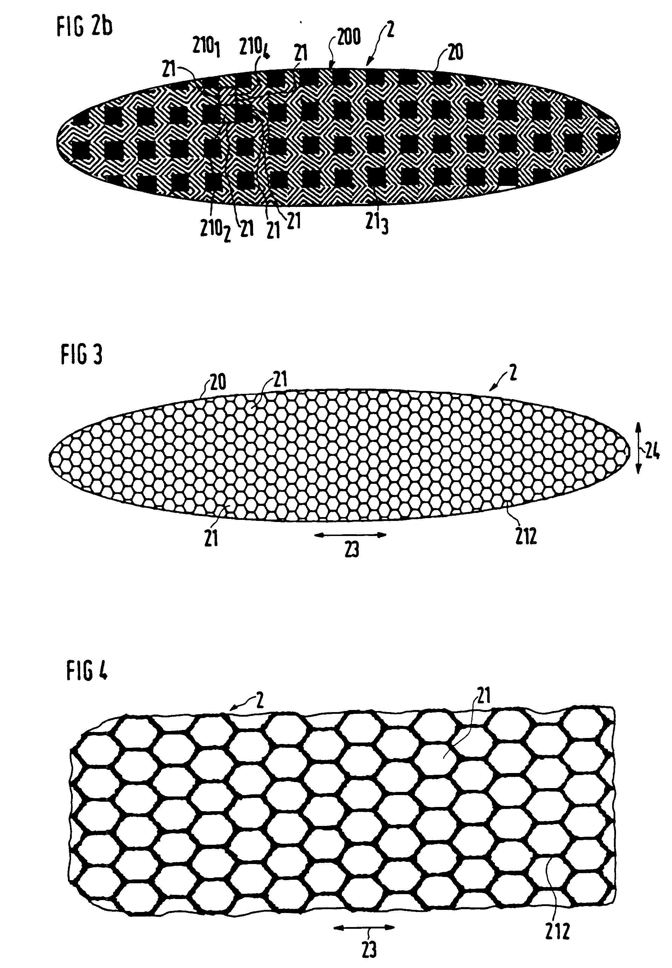

- Figuren 2, 2a und 2b: ein Beispiel einer erfindungsgemäßen diffraktiven Einrichtung, deren lichtbeugende Struktur eine Vielzahl rechteckförmiger, jeweils eine Beugungsgitterstruktur aufweisende Strukturteilbereiche aufweist, wobei sich vier verschiedene Gruppen aus Strukturteilbereichen unterscheiden lassen, welche Gruppen sich durch Beugungsgitterstrukturen in ihren Strukturteilbereichen voneinander unterscheiden, und wobei in Figur 2a die rechteckförmigen Strukturteilbereiche durch eingezeichnete Linien voneinander abgegrenzt und dadurch deutlicher sichtbar gemacht sind und in Figur 2b eine der vier verschiedenen Gruppen aus Strukturteilbereichen durch Schwärzung ihrer Strukturteilbereiche hervorgehoben ist,
- Figur 3: ein Beispiel einer erfindungsgemäßen diffraktiven Einrichtung mit sechseckförmigen Strukturteilbereichen, die ein Wabenmuster bilden,
- Figur 4: eine Modifikation der Einrichtung der Einrichtung nach Figur 3, bei der die sechseckförmigen Strukturteilbereiche in horizontaler Richtung gestreckt sind,
- Figur 5: eine andere Modifikation der Einrichtung nach Figur 3, bei der die sechseckförmigen Strukturteilbereiche in vertikaler Richtung gestreckt sind,
- Figur 6: einen Ausschnitt aus einer erfindungsgemäßen diffraktiven Einrichtung mit beispielsweise viereckigen Strukturteilbereichen, die rein zu Demonstrationszwecken verschiedene Beispiele reliefartigen Beugungsgitterstrukturen enthalten, welche nicht auf eine Viereckform der Strukturteilbereiche beschränkt sind, sondern für alle Strukturteilbereiche verwendet werden können,
- Figur 7: ein Beispiel einer diffraktiven Einrichtung mit vier aneinandergrenzenden Strukturteilbereichen, die sich durch ihre Beugungsgitterstrukturen voneinander unterscheiden und
- Figur 8: ein Beispiel eines synthetischen binären holografischen optischen Elements für eine Strahlaufteilung gemäß Figur 1.

Bei der Anordnung nach Figur 1 sind auf der Oberfläche 50 eines Substrats 5 ein Halbleiter laser 40 und beispielsweise vier optische Empfänger 61 im Abstand voneinander integriert.

Ein Lichtaustrittsfenster des Lasers 40, aus welchem ein Laserstrahl 3 stark divergent und beispielsweise in einer Richtung parallel zur Oberfläche 50 des Substrats 5 aus dem Laser 40 austritt, definiert den einen Raumpunkt 10, und je ein Lichteintrittsfenster jedes optischen Empfängers 61 zum Empfang von Licht definiert jeweils einen anderen Raumpunkt 11₁ bzw. 11₂ bzw. 11₃ bzw. 11₄. Bei der Anordnung nach der Figur 1 ist es so eingerichtet, daß der parallel zur Oberfläche 50 sich ausbreitende Laserstrahl 3 auf eine schräg im Winkel β von beispielsweise von 56° zur Oberfläche 50 stehende Spiegelfläche 51 trifft. Diese Fläche 51 lenkt den Laserstrahl 3 von der Oberfläche 50 fort nach oben um, so daß er sich stark divergent und schräg im Winkel zur Oberfläche 50 ausbreitet und überdies schräg auf eine über der Oberfläche 50 und auf einem Träger 4 befindliche planare lichtbeugende Struktur 2 einer erfindungsgemäßen optischen Einrichtung 1 trifft und diese Struktur 2 be- oder ausleuchtet.

Die beugende Struktur 2 ist so ausgebildet, daß sie auf jeden anderen Raumpunkt 11₁, 11₂, 11₃ und 11₄ einen Leistungsanteil des Laserstrahls 3, in Form eines Teilstrahles 31₁ bzw., 31₂ bzw. 31₃ bzw. 31₄ richtet, wobei die Besonderheit vorliegt, daß die Teilstrahlen 31₁ bzw. 31₂ bzw. 31₃ bzw. 31₄ jeweils konvergent und beispielsweise auf die anderen Raumpunkt 11₁ bzw. 11₂ bzw. 11₃ bzw. 11₄ gebündelt, insbesondere fokussiert sind.

Das in Figur 2 gezeigte Beispiel der beugenden Struktur 2 der diffraktiven Einrichtung 1 nach Figur 1 weist eine Vielzahl von Strukturteilbereichen auf, die von dem Lichtstrahl 3 beleuchtet werden und deren jeder unabhängig von den übrigen Strukturteilbereichen zumindest einen Anteil, im Beispiel speziell einen von der diffraktiven Einrichtung reflektierten Anteil des auf diesen Strukturteilbereich entfallenden Teils des beleuchtenden Lichtstrahls 3 auf einen diesem Strukturteilbereich zugeordneten der vier anderen Raumpunkte bündelt.

Da in der Figur 2 die einzelnen, in diesem Beispiel lückenlos aneinandergrenzenden und rechteckförmigen Strukturteilbereiche nicht so deutlich erkennbar sind, ist die beugende Struktur 2 nach Figur 2 in der Figur 2a noch einmal identisch dargestellt, wobei die einzelnen Strukturteilbereiche 21 durch in der Realität nicht vorhandene horizontale und vertikale Linien gegeneinander abgegrenzt sind, so daß die quadratförmigen und aneinandergrenzenden Strukturteilbereiche 21 deutlich erkennbar sind.

Nach Figur 2a weist jeder Strukturteilbereich 21 eine Beugungsgitterstruktur 210 auf, wobei insgesamt zwei Arten von Beugungsgitterstrukturen zu unterscheiden sind: Die Beugungsgitterstrukturen 210₁ und 210₃, bei denen Gitterlinien schräg von links unten nach rechts oben verlaufen, und die Beugungsgitterstrukturen 210₂ und 210₄, bei denen Gitterlinien von links oben nach rechts unten verlaufen. Die beugende Struktur 2 nach Figur 2 ist in diesem Sinne eine binäre beugende Struktur. Die Beugungsgitterstrukturen 210₁ und 210₃ unterscheiden sich ebenso wie die Beugungsgitterstrukturen 210₂ und 210₄ in der Ausbildung ihrer Gitterlinien. Beispielsweise kann es bezüglich der Ausbildung der Gitterlinien speziell so eingerichtet sein, daß jeder Strukturteilbereich 21 mit einer Beugungsgitterstruktur 210₁ den auf ihn entfallenden Teil des beleuchtenden Lichtstrahls 3 aufgrund der Ausbildung ihrer Gitterlinien auf den ihm zugeordneten anderen Raumpunkt 11₁ bündelt, daß jeder Strukturteilbereich 21 mit einer Beugungsgitterstruktur 210₂ den auf ihn entfallenden Teil des beleuchtenden Lichtstrahls 3 aufgrund der Ausbildung ihrer Gitterlinien auf den ihm zugeordneten anderen Raumpunkt 11₂ bündelt, daß jeder Strukturteilbereich 21 mit einer Beugungsgitterstruktur 210₃ den auf ihn entfallenden Teil des beleuchtenden Lichtstrahls aufgrund der Ausbildung ihrer Gitterlinien auf den ihm zugeordneten anderen Raumpunkt 11₃ bündelt, und daß jeder Strukturteilbereich 21 mit einer Beugungsgitterstruktur 210₄ den auf ihn entfallenden Teil des beleuchtenden Lichtstrahls 3 aufgrund der Ausbildung ihrer Gitterlinien auf den ihm zugeordneten anderen Raumpunkt 11₄ bündelt.

Gemäß Figur 2a ist überdies jedem anderen Raumpunkt 11₁ bzw. 11₂ bzw. 11₃ bzw. 11₄ jeweils eine Gruppe aus mehreren Strukturteilbereichen 21 mit einer Beugungsgitterstruktur 210₁ bzw. 210₂ bzw. 210₃ bzw. 210₄ zugeordnet, deren jeder einen Anteil des auf ihn entfallenden Teils des beleuchtenden Lichtstrahls 3 nur auf diesen anderen Raumpunkt 11₁ bzw. 11₂ bzw. 11₃ bzw. 11₄ bündelt.

Außerdem ist es gemäß Figur 2a speziell und nicht notwendig so eingerichtet, daß sich in der matrixartigen Anordnung der Strukturteilbereiche 21 mit Beugungsgitterstrukturen 210₁ und Strukturteilbereiche 21 mit Beugungsgitterstrukturen 210₄ abwechseln, und horizontale Reihen, in denen sich Strukturteilbereiche 21 mit Beugungsgitterstrukturen 210₂ und Strukturteilbereiche 21 mit Beugungsgitterstrukturen 210₃ abwechseln, in vertikaler Richtung miteinander abwechseln, und daß sich überdies vertikale Spalten, in denen sich Strukturteilbereiche 21 mit Beugungsgitterstrukturen 210₁ und Strukturteilbereiche 21 mit Beugungsgitterstrukturen 210₂ abwechseln, und vertikale Spalten, in den sich Strukturteilbereiche 21 mit Beugungsgitterstrukturen 210₄ und Strukturteilbereiche 21 mit Beugungsgitterstrukturen 210₃ abwechseln, in horizontaler Richtung miteinander abwechseln.

Demnach sind in jeder Gruppe aus mehreren Strukturteilbereichen 21, deren jeder zumindest einen Anteil des auf ihn entfallenden Teils des beleuchtenden Lichtstrahls 3 auf nur einen anderen Raumpunkt 11₁ bzw. 11₂ bzw. 11₃ bzw. 11₄ bündelt, diese Strukturteilbereiche 21 matrixartig und mit Abstand voneinander in horizontalen Reihen und vertikalen Spalten angeordnet und über die ganze vom Lichtstrahl 3 beleuchtete Fläche der beugenden Struktur 2 verteilt.

In der Figur 2b ist beispielsweise die Gruppe 210 aus den mehreren Strukturteilbereichen 21 mit der Beugungsgitterstruktur 210₃, deren jeder zumindest einen Anteil des auf ihn entfallenden Teils des beleuchtenden Lichtstrahls 3 nur auf den anderen Raumpunkt 11₃ bündelt, durch ihre geschwärzten Strukturteilbereiche 21 hervorgehoben, um sie deutlicher sichtbar zu machen. Die Verteilung könnte auch anders, beispielsweise auch unregelmäßig sein.

Jeder Strukturteilbereich 21 nach Figur 2 kann als rechteckförmige, das Licht des Lichtstrahls 3 beugende Apertur aufgefaßt werden, die im Vergleich zur gesamten Apertur oder beleuchteten Fläche der beugenden Struktur 2 klein ist. Ist der rechteckförmige Strukturteilbereich beispielsweise eine auf den zugeordneten anderen Raumpunkt fokussierende Linse mit dieser rechteckförmigen Apertur, so ist das die Intensitätsverteilung eines Fokus beschreibende Beugungsbild in der Bild- oder Brennebene, in welcher dieser andere Raumpunkt liegt, nicht wie bei einer Linse mit kreisrunder Apertur, beispielsweise einer Fresnel-Linse, rotationssymmetrisch, wie es für die meisten Anwendungen erwünscht ist, sondern hat eine Gestalt, die zwei gekreuzten Linien ähnelt (die Beugungsbilder einer Linse mit kreisförmiger und mit rechteckförmiger Apertur können E. Hecht, A. Zajak: "OPTICS", Addison-Wesley-Puplishing Company (1977) entnommen werden). Werden viele solcher rechteckförmiger Aperturen in einer zufällig wirkenden Anordnung zusammengeschaltet, so resultiert ein Beugungsbild in Form eines wesentlich kleineren und wieder mehr runden Flecks, allerdings meist mit strahlenförmigen Ausläufern.

Die Gestalt des Beugungsbildes hängt allerdings auch für eine verteilte Anordnung von Strukturteilbereichen 21 immer noch stark von der Form dieser Strukturteilbereiche 21 ab. Günstig ist eine möglichst runde Form der Strukturteilbereiche 21. Vorteilhaft sind Polygone mit mehr als vier Ecken. Ein sinnvoller Kompromiß zwischen einem möglichst runden Strukturteilbereich 21 und einer beugenden Struktur 2, deren gesamte Apertur oder beleuchtete Fläche lückenlos mit solchen Strukturteilbereichen 21 ausgefüllt werden kann, läßt sich durch sechseckförmige Strukturteilbereiche 21 erreichen. In der Figur 3 ist eine derartige beugende Struktur 2 dargestellt, wobei die in Wirklichkeit nicht notwendig sichtbare sechseckförmige Begrenzung jedes Strukturteilbereiches 21 in Form einer mit 212 bezeichneten schwarzen Umrandung 212 verdeutlicht ist, welche zugleich die Apertur dieses Strukturteilbereiches definiert.

Das Beugungsbild des sechseckförmigen Strukturteilbereiches 21 hat zwar immer noch durch die eckige Form strahlenförmige Ausläufer, doch ergibt sich bei der Überlagerung der Beugungsbilder der Gruppe aus den dem gleichen anderen Raumpunkt zugeordneten sechseckförmigen Strukturteilbereiche 21 ein runderer Fleck, der dem Beugungsbild einer Linse mit kreisrunder Apertur ähnelt.

Um bei beugenden Strukturen 2, die für Anordnungen mit ausgeprägter Off-axis-Geometrie eingesetzt werden sollen, ein möglichst rundes Beugungsbild zu gewährleisten, ist es zweckmäßig, wenn die Strukturteilbereiche 21 in der Ebene der beugenden Struktur 2, d.h. in der jeweiligen Zeichenebene der Figuren 2 bis 8 in der Richtung 22 (siehe Figur 1) des durch die Lage sämtlicher anderen Raumpunkte 11 definierten größten mittleren Ablenkwinkels α zwischen der Achse 30 des Lichtstrahls 3 und einer Achse 310 langgestreckt sind, die allen Teilstrahlen 31 gemeinsam ist, welche von der beugenden Struktur 2 auf die anderen Raumpunkte 11 gerichtet ist. Die Achse 310 ist z.B. die zentrale Achse aller Teilstrahlen 31.

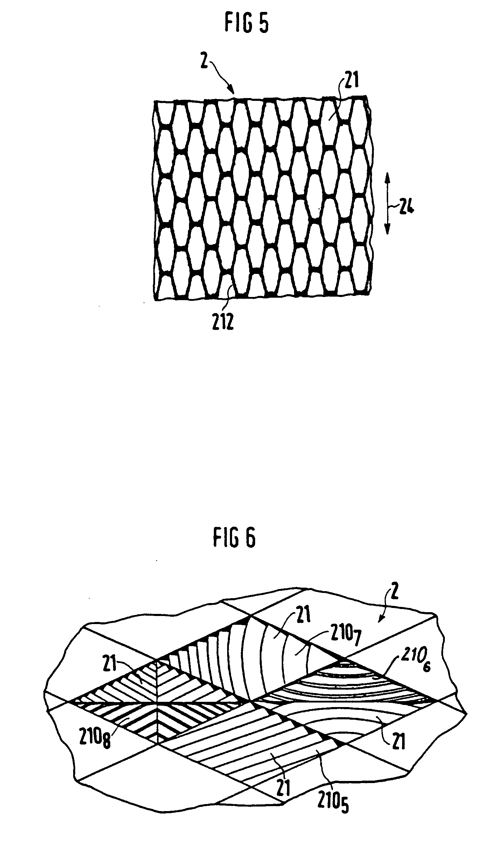

Die Langstreckung ist beispielsweise für sechseckförmige Strukturteilbereiche 21 gemäß Figur 3 möglich. Die Figur 4 zeigt einen Ausschnitt aus einer beispielsweise beugenden Struktur 2 mit ellipsenförmiger Apertur gemäß Figur 3, bei welcher die Strukturteilbereiche 21 in der horizontalen Richtung 23, d.h. in Richtung der großen Halbachse der Ellipse, gestreckt sind, während Figur 5 eine analoge beispielhafte beugende Struktur 2 zeigt, bei welcher die sechseckförmigen Strukturteilbereiche 21 in der vertikalen Richtung 24, d.h. in Richtung der kleinen Halbachse der Ellipse, langgestreckt sind. Die Strukturteilbereiche 21 können auch in jeder beliebigen anderen Richtung gestreckt sein.

Die sechseckförmigen Strukturteilbereiche 21 nach den Figuren 3 bis 5 können Beugungsgitterstrukturen aufweisen, beispielsweise die Beugungsgitterstrukturen 210 nach Figur 2. Mit diesen Beugungsgitterstrukturen 210 ist bei den beugenden Strukturen 2 nach den Figuren 2 bis 5 ein binäres Beugungsmuster gegeben. Derartige beugende Strukturen 2 lassen Beugungswirkungsgrade von maximal 40 % zu. Der Beugungswirkungsgrad kann erhöht werden, wenn die Gitterlinien bzw. -furchen der Beugungsgitterstrukturen in den Strukturteilbereichen 21 profiliert werden.

Bei einfachen Strahlablenkern können z.B. Beugungsgitterstrukturen verwendet werden, deren Gitterfurchen ein sägezahnähnliches Profil aufweisen. Ein Beispiel dafür ist die Beugungsgitterstruktur 210₅ nach Figur 6, die einen Ausschnitt aus einer beugenden Struktur 2 mit rautenförmigen, aber nicht auf diese Form beschränkten Strukturteilbereichen 21 zeigt.

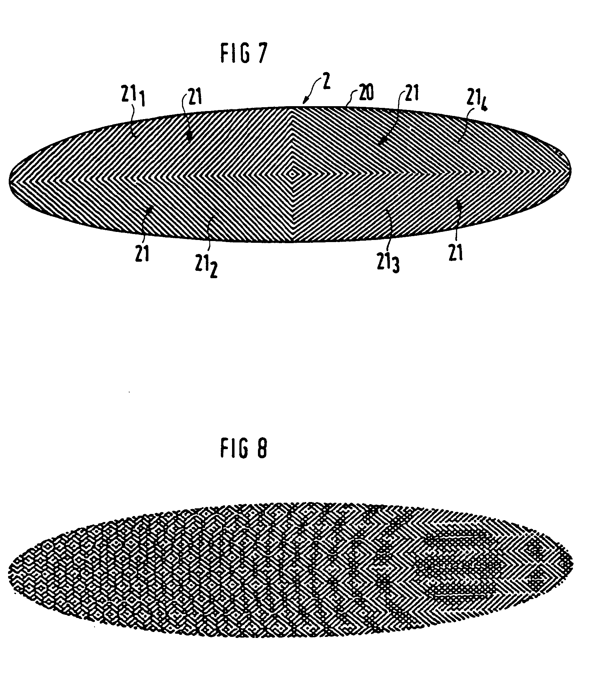

Bei Strahlablenkern, die zugleich Bündeln oder Fokussieren, können beispielsweise Beugungsgitterstrukturen verwendet werden, die Ausschnitte aus Fresnel-Linsen sind. Ein Beispiel dafür ist die Beugungsgitterstruktur 210₇ nach Figur 7.

Auch Kombinationen aus solchen Beugungsgitterstrukturen in einem Strukturteilbereich 21 sind möglich. Ein erstes Beispiel ist die Beugungsgitterstruktur 210₈ nach Figur 6, bei der vier Ausschnitte aus einer Beugungsgitterstruktur mit sägezahnähnlichen Gitterfurchen in einem Strukturteilbereich 21 kombiniert sind, wobei sich die Gitterfurchen ausschnittweise in Richtung oder Profil unterscheiden. Ein weiteres Beispiel ist die Beugungsgitterstruktur 210₆, bei der zwei Ausschnitte aus verschiedenen Fresnel-Linsen in einem Strukturteilbereich kombiniert sind.

Es können auch Beugungsgitterstrukturen mit treppenähnlichem Profil mit beispielsweise vier bis acht Stufen verwendet werden, die z.B. durch mehrstufige Lithographieprozesse hergestellt werden können.

Die Höhe des möglichen Fan out ergibt sich aus der Mindestgröße des einzelnen Strukturteilbereichs 21, der als Facette der beugenden Struktur 2 aufgefaßt werden kann, aus der vom Lichtstrahl 3 ausgeleuchteten Fläche und aus der notwendigen Zahl aus einzelnen Strukturteilbereichen 21, die einer Gruppe von aus denselben anderen Raumpunkten fokussierenden Strukturteilbereichen 21 zugeordnet werden müssen, um die erforderliche Fokusqualität zu erreichen. Ein Fan out bis zu 100 ist möglich.

Die beugende Struktur 2 nach Figur 7 ist ein Beispiel für eine beugende Struktur, bei der jeder Strukturteilbereich 21 einen Teilstrahl 31 auf nur einen anderen der vorhandenen Raumpunkte 11 ablenkt. Beim konkreten Beispiel nach Figur 1 sind nur vier andere Raumpunkte 11 vorhanden, so daß die beugende Struktur 2 nur vier Strukturteilbereiche 21 aufweist. Jeder der vier Strukturteilbereiche 21 weist eine andere Beugungsgitterstruktur auf, die so ausgebildet ist, daß sie allein einen Teilstrahl 31 auf den zugeordneten anderen Raumpunkt 11 richtet. Beispielsweise kann es so eingerichtet sein, daß die Beugungsgitterstruktur 21₁ den Teilstrahl 31₁ auf den anderen Raumpunkt 11₁, die Beugungsgitterstruktur 21₂ den Teilstrahl 31₂ auf den anderen Raumpunkt 11₂, die Beugungsgitterstruktur 21₃ den Teilstrahl 31₃ auf den anderen Raumpunkt 11₃ und die Beugungsgitterstruktur 21₄ den Teilstrahl 31₄ auf den anderen Raumpunkt 11₄ richtet, bündelt oder fokussiert.

Eine erfindungsgemäße beugende Struktur 2 kann durch einen Rand 20 begrenzt sein, der die Apertur dieser Struktur 2 definiert und ellipsenförmig oder anders geformt sein kann. Es kann aber auch so sein, daß die beugende Struktur 2 keinen solchen Rand 20 aufweist, sondern sich beispielsweise über die ganze Fläche des Trägers 4 nach Figur 1 erstreckt. Die Apertur der Struktur 2 ist dann allein durch den Bereich bestimmt, der vom Lichtstrahl 3 ausgeleuchtet wird. Im Falle eines schräg einfallenden Lichtstrahls 3 mit kreisförmigem Querschnitt ist der ausgeleuchtete Bereich ellipsenförmig, so wie in den Figuren 2, 3 und 7 dargestellt.

Das synthetische binäre holografische optische Element nach Figur 8 weist keine erfindunsgemäßen Strukturteilbereiche auf und dient allein zum Vergleich mit den erfindungsgemäßen beugenden Strukturen.

## Patentansprüche

1. Diffraktive optische Einrichtung (1) zur optischen Abbildung eines definierten Raumpunktes (10) auf zumindest zwei andere Raumpunkte (11), bestehend aus
- einer flächenhaft ausgedehnten, definiert lichtbeugenden Struktur (2) zur Beleuchtung mit einem Lichtstrahl (3) von dem einen Raumpunkt (10) her,
- wobei die lichtbeugende Struktur (2) mehrere Strukturteilbereiche (21) aufweist, deren jeder (21) zumindest einen Anteil eines auf diesen Strukturteilbereich (21) fallenden beleuchtenden Lichtstrahls (3) auf einen diesem Strukturteilbereich (21) zugeordneten anderen Raumpunkt (11) derart richtet, daß Anteile des auf die lichtbeugende Struktur (2) fallenden Lichtstrahls (3) auf jeden der anderen Raumpunkte (11) gerichtet sind, und
- wobei eine Gruppe (200) aus wenigstens zwei mit Abstand voneinander angeordneten Strukturteilbereichen (21) Licht auf nur einen der wenigstens zwei anderen Raumpunkte (11) richtet, so daß jeder Strukturteilbereich (21) dieser Gruppe (200) Licht, das auf diese Gruppe (200) trifft, nur auf diesen einen anderen Raumpunkt (21) und nicht auf einen von diesem anderen Raumpunkt (21) verschiedenen anderen Raumpunkt (21) richtet.

2. Einrichtung nach Anspruch 1, wobei die Strukturteilbereiche (21) der Gruppe (200) über die ganze Fläche der lichtbeugenden Struktur (2) verteilt sind.

3. Einrichtung nach Anspruch 1 oder 2, wobei die Strukturteilbereiche (21) der lichtbeugenden Struktur (2) lückenlos aneinandergrenzen.

4. Einrichtung nach Anspruch 3, wobei jeder Strukturteilbereich (21) ein Polygon (211, 212, 213) definiert.

5. Einrichtung nach Anspruch 4, wobei jeder Strukturteilbereich (21) ein Sechseck (212) definiert.

6. Einrichtung nach einem der vorhergehenden Ansprüche, wobei jeder Strukturteilbereich (21) eine Beugungsgitterstruktur (210) aufweist.

7. Einrichtung nach Anspruch 6, wobei die Beugungsgitterstrukturen (210) von Strukturteilbereichen (21), die Licht auf voneinander verschiedene andere Raumpunkte (11) richten, voneinander verschieden sind.

8. Einrichtung nach Anspruch 7, wobei die Beugungsgitterstrukturen (210) der Strukturteilbereiche (21) jeder Gruppe (200), die Licht auf nur einen anderen Raumpunkt (11) richten, Ausschnitte aus einer gemeinsamen übergeordneten Struktur sind.

9. Einrichtung nach einem der Ansprüche 6 bis 8, wobei die Beugungsgitterstruktur (210) eines Strukturteilbereichs (21) reliefartig ist.

10. Einrichtung nach Anspruch 9, wobei eine reliefartige Beugungsgitterstruktur (210) ein Sägezahnprofil aufweist.

11. Einrichtung nach Anspruch 9 oder 10, wobei eine reliefartige Beugungsgitterstruktur (210) ein gestuftes Profil aufweist.

12. Einrichtung nach Anspruch 11, wobei das gestufte Profil ein treppenartig gestuftes Profil ist.

13. Einrichtung nach einem der Ansprüche 9 bis 12, wobei eine reliefartige Beugungsgitterstruktur (210) einem Ausschnitt aus einer Fresnelschen Zonenlinse entspricht.

14. Einrichtung nach einem der vorhergehenden Ansprüche, wobei die Fläche der beugenden Struktur (2) einen eine Apertur der Einrichtung definierenden ovalen Rand (20) aufweist.

15. Einrichtung nach einem der vorhergehenden Ansprüche, insbesondere nach Anspruch 3 oder 4, wobei die Strukturteilbereiche (21) in der Fläche der beugenden Struktur (2) in Richtung (22) eines durch die Lage sämtlicher anderen Raumpunkte (11) definierten größten mittleren Ablenkwinkels (α) zwischen einer Achse (30) des Lichtstrahls (3) und einer allen von der beugenden Struktur (2) auf die anderen Raumpunkte (11) gerichteten Teilstrahlen (31) gemeinsamen Achse (310) langgestreckt sind.

16. Einrichtung nach einem der vorhergehenden Ansprüche, wobei der eine Raumpunkt (11) (10) durch ein Austrittsfenster eines den Lichtstrahl (3) erzeugenden optischen Senders (40) definiert ist.

17. Einrichtung nach einem der vorhergehenden Ansprüche, wobei ein anderer Raumpunkt (11) durch ein Lichteintrittsfenster eines optischen Empfängers (61) zum Empfang einer Lichtleistung des auf dieses Fenster gerichteten Anteils (31) des Lichtstrahls (3) definiert ist.

## Claims

1. Diffractive optical device (1) for optically imaging a defined space point (10) onto at least two other space points (11), comprising
- a two-dimensionally extended structure (2), which diffracts light in a defined fashion, for illuminating with the aid of a light beam (3) from one space point (10),
- the light-diffracting structure (2) having several structural subregions (21), each (21) of which directs at least a fraction of an illuminating light beam (3) falling onto this structural subregion (21) onto another space point (11), assigned to this structural subregion (21), in such a way that fractions of the light beam (3) falling onto the light-diffracting structure (2) are directed onto each of the other space points (11), and
- a group (200) of at least two structural subregions (21) arranged at a spacing from one another directs light onto only one of the at least two other space points (11), such that each structural subregion (21) of this group (200) directs light striking this group (200) only onto this one other space point (21) and not onto another space point (21) differing from this other space point (21).

2. Device according to Claim 1, the structural subregions (21) of the group (200) being distributed over the entire surface of the light-diffracting structure (2).

3. Device according to Claim 1 or 2, the structural subregions (21) of the light-diffracting structure (2) adjoining one another without gaps.

4. Device according to Claim 3, each structural subregion (21) defining a polygon (211, 212, 213).

5. Device according to Claim 4, each structural subregion (21) defining a hexagon (212).

6. Device according to one of the preceding claims, each structural subregion (21) having a diffraction grating structure (210).

7. Device according to Claim 6, the diffraction grating structures (210) of structural subregions (21), which direct light onto mutually differing other space points (11), differing from one another.

8. Device according to Claim 7, the diffraction grating structures (210) of the structural subregions (21) of each group (200), which direct light onto only one other space point (11), being sections from a common master structure.

9. Device according to one of Claims 6 to 8, the diffraction grating structure (210) of a structural subregion (21) exhibiting relief.

10. Device according to Claim 9, a relief-type diffraction grating structure (210) having a sawtooth profile.

11. Device according to Claim 9 or 10, a relief-type diffraction grating structure (210) having a graduated profile.

12. Device according to Claim 11, the graduated profile being a stepped profile.

13. Device according to one of Claims 9 to 12, a relief-type diffraction grating structure (210) corresponding to a section from a Fresnel zone plate.

14. Device according to one of the preceding claims, the surface of the diffracting structure (2) having an oval edge (20) defining an aperture of the device.

15. Device according to one of the preceding claims, in particular according to Claim 3 or 4, the structural subregions (21) in the surface of the diffracting structure (2) being longitudinally extended in the direction (22) of a largest mean deflecting angle (a) defined by the position of all the other space points (11), between an axis (30) of the light beam (3) and an axis (310) common to all component beams (31) directed from the diffracting structure (2) onto the other space points (11).

16. Device according to one of the preceding claims, one space point (11), (10) being defined by an exit window of an optical transmitter (40) generating the light beam (3).

17. Device according to one of the preceding claims, another space point (11) being defined by a light entry window of an optical receiver (61) for receiving a light power of the component (31), directed onto this window, of the light beam (3).

## Revendications

1. Dispositif (1) optique de diffraction pour la reproduction optique d'un point spatial (10) défini sur au moins deux autres points spatiaux (11), formé par
- une structure (2) étendue sur deux dimensions et diffractant la lumière d'une manière définie, destinée à être éclairée par un faisceau lumineux (3) depuis ledit point spatial (10),
- la structure (2) diffractant la lumière comprenant plusieurs zones partielles de structure (21) dont chacune (21) dirige au moins une portion d'un faisceau lumineux (3) d'éclairage tombant sur cette zone partielle de structure (21) sur un autre point spatial (11) associé à cette zone partielle de structure (21) de manière à ce que des portions du faisceau lumineux (3) tombant sur la structure (2) diffractant la lumière soient dirigées sur chacun des autres points spatiaux (11), et
- un groupe (200) formé d'au moins deux zones partielles de structure (21) situées à une distance l'une de l'autre dirigeant de la lumière sur seulement un des au moins deux autres points spatiaux (11), de manière à ce que chaque zone partielle de structure (21) de ce groupe (200) dirige de la lumière arrivant sur ce groupe (200) uniquement sur cet autre point spatial (21) et non pas sur un autre point spatial (21) différent de cet autre point spatial (21).

2. Dispositif selon la revendication 1, les zones partielles de structure (21) du groupe (200) étant réparties sur toute la surface de la structure (2) diffractant la lumière.

3. Dispositif selon l'une des revendications 1 ou 2, les zones partielles de structure (21) de la structure (2) diffractant la lumière étant contiguës sans vide entre elles.

4. Dispositif selon la revendication 3, chaque zone partielle de structure (21) définissant un polygone (211, 212, 213).

5. Dispositif selon la revendication 4, chaque zone partielle de structure (21) définissant un hexagone (212).

6. Dispositif selon l'une quelconque des revendications précédentes, chaque zone partielle de structure (21) comportant une structure de réseau de diffraction (210).

7. Dispositif selon la revendication 6, les structures de réseau de diffraction (210) de zones partielles de structure (21) dirigeant de la lumière sur d'autres points spatiaux (11) différant les uns des autres sont différentes les unes des autres.

8. Dispositif selon la revendication 7, les structures de réseau de diffraction (210) des zones partielles de structure (21) de chaque groupe (200), qui dirigent la lumière sur un seul autre point spatial (11), sont des coupes d'une structure supérieure commune.

9. Dispositif selon l'une des revendications 6 à 8, la structure de réseau de diffraction (210) d'une zone partielle de structure (21) étant en relief.

10. Dispositif selon la revendication 9, une structure de réseau de diffraction (210) en relief présentant un profil en dents de scie.

11. Dispositif selon l'une des revendications 9 ou 10, une structure de réseau de diffraction (210) en relief présentant un profil étagé.

12. Dispositif selon la revendication 11, le profil étagé étant un profil étagé à la manière d'un escalier.

13. Dispositif selon l'une des revendications 9 à 12, une structure de réseau de diffraction (210) en relief correspondant à une coupe d'une lentille de Fresnel.

14. Dispositif selon l'une des revendications précédentes, la surface de la structure diffractante (2) étant pourvue d'un bord (20) ovale qui définit une ouverture du dispositif.

15. Dispositif selon l'une quelconque des revendications précédentes, notamment selon l'une des revendications 3 ou 4, les zones partielles de structure (21) dans la surface de la structure diffractante (2) étant allongées dans la direction (22) d'un angle de déviation moyen maximum (α), défini par la position de tous les autres points spatiaux (11), entre un axe (30) du faisceau lumineux (3) et un axe (310) commun à tous les faisceaux partiels (31) dirigés par la structure diffractante (2) sur les autres points spatiaux (11).

16. Dispositif selon l'une quelconque des revendications précédentes, le point spatial (11) (10) étant défini par une fenêtre de sortie d'un émetteur optique (40) produisant le faisceau lumineux (3).

17. Dispositif selon l'une quelconque des revendications précédentes, un autre point spatial (11) étant défini par une fenêtre d'entrée de la lumière d'un récepteur optique (61) destiné à recevoir une puissance lumineuse de la portion (31) du faisceau lumineux (3) dirigée sur cette fenêtre.
